# EUROPÄISCHE PATENTSCHRIFT

(11) **EP 2 452 116 B1**
(45) Veröffentlichungstag und Bekanntmachung des Hinweises auf die Patenterteilung: **05.09.2018**
(21) Anmeldenummer: 10723613.5
(22) Anmeldetag: 16.06.2010
(51) Int. Cl.: H05K 1/18, H05K 3/28, F21S 4/22, F21Y 103/10, F21Y 115/10

(54) **LEUCHTVORRICHTUNG MIT EINER FLEXIBLEN LEITERPLATTE**
LIGHT-EMITTING DEVICE COMPRISING A FLEXIBLE WIRING BOARD
DISPOSITIF D'ÉCLAIRAGE COMPORTANT UN CIRCUIT IMPRIMÉ FLEXIBLE

(30) Priorität: 09.07.2009 DE 102009032424
(43) Veröffentlichungstag der Anmeldung: 16.05.2012
(73) Patentinhaber: OSRAM GmbH, 80807 München (DE)
(72) Erfinder: PREUSCHL, Thomas, 93161 Sinzing (DE); STRAUSS, Steffen, 93047 Regensburg (DE); ZEUS, Florian, 93197 Zeitlarn (DE)
(86) Internationale Anmeldenummer: PCT/EP2010/058488
(87) Internationale Veröffentlichungsnummer: WO 2011/003713

(56) Entgegenhaltungen:
- EP-A2- 0 760 448
- US-A- 4 761 720
- US-A- 5 559 681
- US-A1- 2007 121 326

## Beschreibung

Die Erfindung betrifft eine Leuchtvorrichtung mit mindestens einer flexiblen Leiterplatte und ein Verfahren zur Herstellung einer solchen Leuchtvorrichtung.

Es sind mit Leuchtdioden bestückte flexible Leiterplatten ('Flexbänder') bekannt, die zum IP-Schutz vollständig mit Vergussmasse umspritzt worden sind. Jedoch geht dabei aufgrund von signifikanten Lichtverlusten in der Vergussmasse Strahlungseffizienz verloren. Um die Strahlungseffizienz nicht zu verschlechtern, ist es als Alternative bekannt, dass die Vergussmasse die Oberkante der LED(s) nicht überragt und die LED(S) somit mit ihrer typischen obenliegenden Leuchtfläche nicht mehr von der Vergussmasse bedeckt ist bzw. sind. Bei dieser Alternative besteht dafür die Gefahr, dass sich bei einer Biegung Risse zwischen der Vergussmasse und der Gehäuseseite der LED bilden, welche zu Undichtigkeiten und einem Eindringen von Feuchtigkeit, Staub usw. in das Flexband führen können.

Eine Leuchtvorrichtung, gemäß dem Oberbegriff von Anspruch 1 ist im Dokument US-A1-2007/121326 gezeigt. Es ist die Aufgabe der vorliegenden Erfindung, eine Leuchtvorrichtung mit eine flexiblen Leiterplatte bereitzustellen, welche bei hohem IP-Schutz (hohe IP-Schutzklasse) keine wesentliche Verminderung der Strahlungseffizienz aufweist.

Diese Aufgabe wird mittels einer Leuchtvorrichtung und eines Verfahrens zum Herstellen einer Leuchtvorrichtung nach dem jeweiligen unabhängigen Anspruch gelöst. Bevorzugte Ausführungsformen sind insbesondere den abhängigen Ansprüchen entnehmbar.

Die Leuchtvorrichtung weist mindestens eine flexible Leiterplatte ('Flexband') auf, die mit mindestens einer Halbleiterlichtquelle bestückt ist, wobei mindestens eine bestückte Seite der Leiterplatte mit einem Vergussmaterial belegt ist, welches zumindest eine Abstrahlfläche der Halbleiterlichtquelle freilässt, und wobei die Halbleiterlichtquelle zumindest teilweise von einem Haftelement abgedeckt ist, wobei das Haftelement (i) teilweise aus der Vergussmasse ragt, (ii) von der Vergussmasse haftend seitlich umgeben ist und (iii) eine bessere Haftung mit der Vergussmasse aufweist als die Halbleiterlichtquelle.

Ein mögliches bestücktes Flexband kann ein Flexband der LI-NEARLight-Reihe der Fa. OSRAM sein.

Die Art der Halbleiter-Lichtquelle ist grundsätzlich nicht beschränkt, jedoch wird als Emitter eine LED oder eine Laserdiode bevorzugt. Die Halbleiter-Lichtquelle kann ein oder mehrere Halbleiter-Emitter aufweisen. Der oder die Halbleiter-Emitter können auf einem Träger aufgebracht sein, auf dem auf weitere elektronische Bausteine wie Widerstände, Kondensatoren, Logikbausteine usw. montiert sein können. Die Halbleiter-Emitter können beispielsweise mittels herkömmlicher Lötverfahren auf der Leiterplatte aufgebracht sein. Die Halbleiter-Emitter können aber auch durch Chip-Level-Verbindungsarten, wie Bonden (Drahtbonden, Flip-Chip-Bonden) usw. mit einem Substrat verbunden sein ("Submount"), z. B. durch Bestückung eines Substrats aus AlN mit LED-Chips. Auch können ein oder mehrere Submounts auf einer Leiterplatte montiert sein.

Bei Vorliegen mehrerer Halbleiter-Emitter können diese in der gleichen Farbe strahlen, z. B. weiß, was eine einfache Skalierbarkeit der Helligkeit ermöglicht. Die Halbleiter-Emitter können aber zumindest teilweise auch eine unterschiedliche Strahlfarbe aufweisen, z. B. rot (R), grün (G), blau(B), bernstein (A) und / oder weiß (W). Dadurch kann ggf. eine Strahlfarbe der Lichtquelle durchgestimmt werden, und es kann ein beliebiger Farbpunkt eingestellt werden. Insbesondere kann es bevorzugt sein, wenn Halbleiter-Emitter unterschiedlicher Strahlfarbe ein weißes Mischlicht erzeugen können. Anstelle oder zusätzlich zu anorganischen Leuchtdioden, z. B. auf Basis von InGaN oder AlInGaP, sind allgemein auch organische LEDs (OLEDs) einsetzbar. Auch können z. B. Diodenlaser verwendet werden.

Dass das Haftelement aus der Vergussmasse ragt, bedeutet, dass es teilweise unterhalb einer Oberfläche der Vergussmasse liegt und folglich mit diesem Teil in die Vergussmasse eingebettet ist und teilweise oberhalb der Oberfläche der Vergussmasse liegt. Der unterhalb der Oberfläche der Vergussmasse liegende Teil ist somit von der Vergussmasse umgeben, und zwar zumindest seitlich. Da das Haftelement die Halbleiterlichtquelle zumindest teilweise überdeckt, kann die Halbleiterlichtquelle also unterhalb der Oberfläche der Vergussmasse liegen; kann die Vergussmasse in anderen Worten also nach oben über die Halbleiterlichtquelle reichen.

Dadurch, dass das Haftelement eine bessere Haftung mit der Vergussmasse aufweist als die Halbleiterlichtquelle, kann eine Rissbildung an der Grenzfläche zwischen Vergussmasse und Haftelement im Vergleich zur Haftung zwischen Vergussmasse und Leuchtelement unterdrückt werden, wodurch ein zuverlässigerer IP-Schutz auch bei stärkeren Biegungen aufrechterhalten werden kann, und zwar ohne dass die Vergussmasse die Leuchteffizienz beeinträchtigt.

Das Haftelement kann vorteilhafterweise eine Oberseite der jeweiligen Halbleiterlichtquelle vollständig überdecken. Dadurch wird eine besonders geringe Verformung des Haftelements unter einer Biegebeanspruchung erreicht. Zudem kann, wie weiter unter ausgeführt, das Haftelement zur Lichtführung ausgestaltet werden. Es ist dann ferner besonders einfach handhabbar.

Jedoch kann alternativ auch ein die Oberseite der jeweiligen Halbleiterlichtquelle nicht vollständig überdeckendes Haftelement vorteilhaft verwendet werden, z. B. ein ringförmiges Haftelement. Ein solches Haftelement besitzt den Vorteil, dass es die Leuchtfläche des Halbleiterleuchtelements außenseitig umgeben kann und die Leuchtfläche dabei freiliegt, so dass weiterhin eine verbesserte Haftung an der Oberfläche der Vergussmasse nur zwischen dem Haftelement und der Vergussmasse vorliegt, aber gleichzeitig keine Lichtabsorption durch ein die Halbleiterlichtquelle abdeckendes Material stattfindet.

Das Haftelement kann vorteilhafterweise einen von der Vergussmasse bedeckten seitlichen Vorsprung aufweisen. Dadurch wird die Haftung mit der Vergussmasse aufgrund einer größeren gemeinsamen Grenzfläche verbessert. Zudem wird eine Handhabung des Haftelements erleichtert.

Das Haftelement kann vorteilhafterweise die jeweilige Halbleiterlichtquelle seitlich zumindest teilweise gegenüber der Vergussmasse abdecken. Dadurch kann ein Haftung in Tiefenbereichen weiter verbessert werden und so eine Rissausbreitung in die Tiefe entlang der Grenzfläche der Vergussmasse bei bereits vorliegenden Oberflächenrissen erschweren.

Vorteilhafterweise kann eine Wanddicke eines die jeweilige Halbleiterlichtquelle seitlich abdeckenden Bereichs des Haftelements größtenteils 0,2 mm bis 1 mm betragen.

Es kann zur Verhinderung einer Rissausbreitung bis zur Leiterplatte besonders vorteilhaft sein, wenn das Haftelement die jeweilige Halbleiterlichtquelle seitlich vollständig abdeckt. Ferner kann dadurch die Halbleiterlichtquelle auch während des Vergießens gegen das flüssige Vergussmaterial geschützt werden, insbesondere, falls das Vergussmaterial ein Schmelzklebstoff ist.

Zum Stoppen einer Rissausbreitung in die Tiefe entlang der Grenzfläche zwischen Haftelement und Vergussmasse kann es besonders vorteilhaft sein, wenn das Haftelement einen umlaufenden, nach oben gebogenen Vorsprung oder Kragen ('Hutkragen') aufweist. Eine Rissspitze kann dann mittels des Kragens gestoppt werden, so dass ein Abheben der Vergussmasse von der Leiterbahn stark behindert werden kann. Zudem ergibt sich eine gute formschlüssige Verbindung zwischen dem Haftelement und der Vergussmasse.

Dabei kann dieser Kragen zur einfachen Herstellung vorteilhafterweise an einem unteren Rand des Haftelements vorhanden sein.

Es kann zur Erreichung einer kompakten Bauweise und eines besonders geringen Lichtverlusts vorteilhaft sein, wenn das Haftelement ein optisches Element, insbesondere Linse, aufweist, welches der Halbleiterlichtquelle optisch nachgeschaltet ist. Das optische Element kann z. B. zur Strahlführung oder zum Schutz (Schutzlinse, Abdecklinse) dienen. Das optische Element kann insbesondere die Lichtabstrahlfläche(n) der Halbleiterlichtquelle überdecken. Das optische Element kann vorteilhafterweise ein integraler oder einstückiger Bestandteil des Haftelements sein.

Vorteilhafterweise kann das Haftelement oder als Teil davon das optische Element mittels eines Immersionsmaterials (engl. 'index-matching material') mit der Halbleiterlichtquelle verbunden sein, da so eine Fresnel'sche Reflektion an der Oberfläche des optischen Elements verringert werden kann.

Vorteilhafterweise kann ein Material des Haftelements oder als Teil davon des optischen Elements Makrolon, Silikon und / oder Glas aufweisen. Makrolon ist der der Markenname für ein von der Bayer AG, Deutschland, entwickeltes Polycarbonat, welches transparent ist (wobei eine Einfärbung möglich ist), eine sehr hohe Bruchfestigkeit aufweist, sehr leicht ist und zudem auch bei hohen Temperaturen ein hohes Maß an Formstabilität aufweist. Es sind auch Materialkombinationen möglich, z. B. ein Vorsehen einer Glaslinse unter einer Makrolonfolie. Die genannten Materialien haften besonders gut mit einer Vergussmasse aus sog. Hotmelt. Insbesondere weist das Material des Haftelements oder des optischen Elements eine geringere Lichtabsorption auf als die Vergussmasse.

Vorteilhafterweise kann die Vergussmasse einen Heißklebstoff (auch Schmelzklebstoff oder Hotmelt genannt) aufweisen, insbesondere vollständig daraus bestehen, da sich so eine besonders einfache und preiswerte Herstellung erreichen lässt.

Das Verfahren dient zur Herstellung einer Leuchtvorrichtung und weist mindestens die folgenden Schritte auf: Zusammendrücken mindestens eines Haftelements mit einer jeweiligen auf der Leiterplatte befestigten Halbleiterlichtquelle; und Vergießen der bestückten Leiterplatte und des mindestens einen Haftelements.

Es kann vorteilhaft sein, wenn diesen Schritten ein Schritt eines Einlegens mindestens eines Haftelements in ein Werkzeug vorangeht.

Es kann aber auch vorteilhaft sein, wenn diesen Schritten ein Schritt eines Aufsetzens mindestens eines Haftelements auf eine zugehörige Halbleiterlichtquelle vorangeht oder damit gleichzeitig ausgeführt wird.

In den folgenden Figuren wird die Erfindung anhand von Ausführungsbeispielen schematisch genauer beschrieben. Dabei können zur besseren Übersichtlichkeit gleiche oder gleichwirkende Elemente mit gleichen Bezugszeichen versehen sein.
- FIG 1: zeigt als Schnittdarstellung in Seitenansicht einen Ausschnitt aus einer Leuchtvorrichtung gemäß einer ersten Ausführungsform;
- FIG 2: zeigt als Schnittdarstellung in Seitenansicht einen Ausschnitt aus einer Leuchtvorrichtung gemäß einer zweiten Ausführungsform;
- FIG 3: zeigt in Aufsicht ein Werkzeug zum Herstellen einer Leuchtvorrichtung.

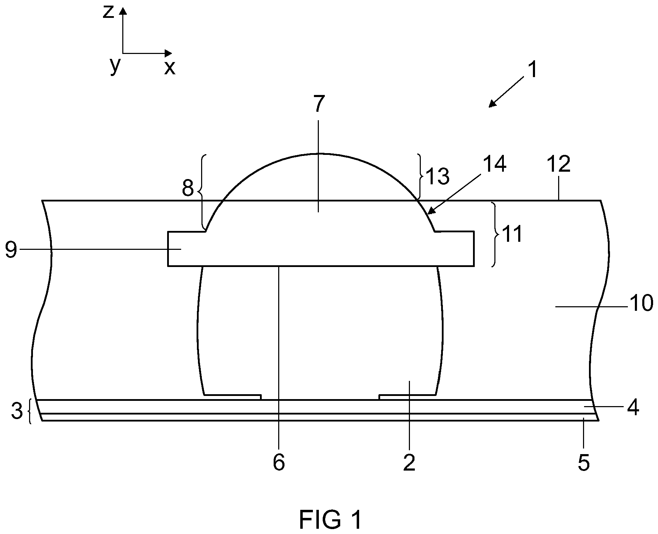

FIG 1 zeigt als Schnittdarstellung in Seitenansicht eine Leuchtvorrichtung 1 gemäß einer ersten Ausführungsform im Bereich einer Halbleiterlichtquelle in Form einer Leuchtdiode 2. Die Leuchtdiode 2 ist unterseitig auf einer bandförmigen flexiblen Leiterplatte ('Flexband') 3 befestigt und strahlt hauptsächlich nach oben (entlang der z-Achse) ab. Das Flexband 3 ist einseitig bestückt und weist eine Basislage 4 aus einem flexiblen isolierenden Leiterplattenmaterial auf, z. B. Polyimid. Das Flexband 3 ist zur elektrischen Verdrahtung der Leuchtdiode 2 und ggf. weiterer elektronischer Bauelemente an seiner Unterseite mit einer Verdrahtungslage 5 in Form einer Kupferkaschierung belegt. Eine Oberseite 6 der Leuchtdiode 2, welche auch die Leuchtfläche aufweist, ist vollständig und flächig von einem Haftelement 7 abgedeckt. Das Haftelement 7 ragt seitlich umlaufend (in einer zur z-Achse senkrechten (x,y)-Ebene) über die Leuchtdiode 2 heraus. Das Haftelement 7 weist genauer gesagt einen linsenförmigen Teil bzw. eine integrale Linse 8 auf als auch einen umlaufenden kragenförmigen Teil bzw. Kragen 9. Die bestückte Seite des Flexbands 3 ist mittels einer Vergussmasse 10 in Form eines Heißklebstoffs ('Hotmelt') so vergossen, dass die Leuchtdiode 2 und ein (unterer) Teil 11 des Haftelements 7 in die Vergussmasse 10 eingebettet sind. In anderen Worten steht eine freie Oberfläche 12 der Vergussmasse 10 höher als die obere Oberfläche 6 der Leuchtdiode und höher als ein eingebetteter Teil 11 des Haftelements 7. Folglich ragt ein (oberer) Teil 13 des Haftelements 7 aus der Vergussmasse 10 heraus.

Mittels der Linse 8 wird aus der Oberfläche 6 der Leuchtdiode 2 nach oben austretendes Licht unter vernachlässigender Lichtabsorption im Haftelement 7 mittels des linsenförmigen Teils 8 des Haftelements 7 im Wesentlichen in den oberen Teil 13 des Haftelements 7 geleitet und von dort weiter nach Außen. Mittels des Kragens 9 wird erstens eine vergleichsweise große Grenzfläche oder Kontaktfläche zwischen dem Haftelement 7 und der Vergussmasse 10 geschaffen, was eine Haftung verbessert. Zweitens wird durch die über dem Kragen befindliche Vergussmasse eine Ablösung oder ein Abheben des Haftelements 7 von der Leuchtdiode 2 verhindert. Das Haftelement 7 ist zur Sicherstellung einer flächigen Verbindung mit der Leuchtdiode 2 über eine Schicht aus Immersionsmaterial (o. Abb.) verbunden.

Bei einer Biegung der Leuchtvorrichtung 1 entlang ihrer Längserstreckung (entlang der x-Achse) bilden sich an der oberen Oberfläche Zugspannungen, die zu einer Rissbildung führen können. Dabei wird eine Rissbildung aufgrund der vergleichsweise rissunanfälligen Vergussmasse 10 vorzugsweise an einer Grenzfläche 14 zwischen der Vergussmasse 10 und dem Haftelement 7 auftreten. Da jedoch die Haftung zwischen dem Haftelement 7 und der Vergussmasse 10 besser ist als zwischen der Leuchtdiode 2 und der Vergussmasse 10 in einem ähnlichen Aufbau, kann eine Rissbildung und damit Beschädigung der Leuchtvorrichtung 1 unterdrückt werden. Insgesamt kann somit ein hoher IP-Schutz ohne wesentliche Verminderung der Strahlungseffizienz erreicht werden.

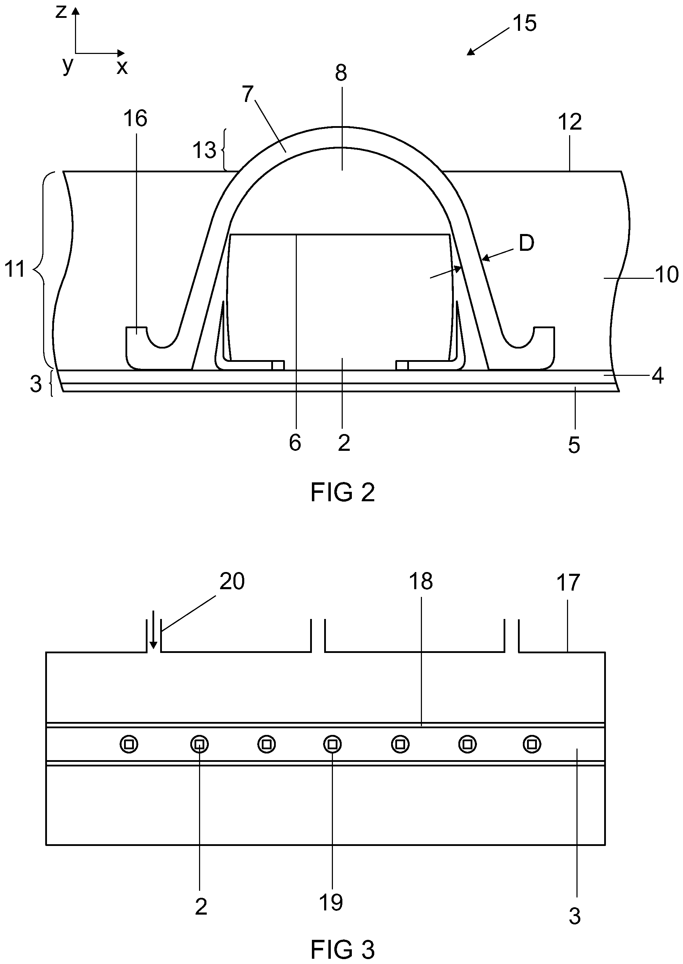

FIG 2 zeigt als Schnittdarstellung in Seitenansicht einen Ausschnitt aus einer Leuchtvorrichtung 15 gemäß einer zweiten Ausführungsform. Im Gegensatz zu der in FIG 1 dargestellten ersten Ausführungsform ist nun das Haftelement 7 glockenförmig ausgeführt, d. h., dass es sich von oben nach unten zum Flexband 3 hin aufweitet und die Leuchtdiode 2 vollständig oben und seitlich überdeckt und damit vollständig von der Vergussmasse 10 abschirmt. Dadurch wird erstens eine besonders starke Haftung und folglich Unterdrückung einer Rissbildung erreicht, und zweitens kann eine thermische Belastung der Leuchtdiode 2 während eines Heissvergießens vermindert werden. Das Haftelement 7 weist wiederum einen linsenförmigen Teil 8 auf, welcher das von einer Oberseite der LED 2 abgestrahlte Licht ohne oder ohne wesentlichen Durchgang durch die Vergussmasse 10 nach außen abgibt. Das Haftelement 7 weist an seinem unteren Rand einen nach oben umgeschlagenen Kragen 16, der auf dem Flexband 3 aufliegt. Mittels des Kragens 16 kann erstens eine Rissausbreitung entlang der Grenzfläche zwischen dem Haftelement 7 und der Vergussmasse 10 vor Erreichen des Flexbands 3 gestoppt werden, und zweitens kann so eine gute Formschlüssigkeit der Verbindung zwischen dem Haftelement 7 und der Vergussmasse 10 erreicht werden. Das Haftelement 7 ist als einstückiger Glaskörper ausgeführt.

Die Linse 8 kann aus dem gleichen Material wie der Rest des Haftelements 7 bestehen, das Haftelement 7 also insbesondere aus einem einzigen Material oder Materialverbund bestehen oder als Volumen aus einem vom Rest des Haftelements 7 unterschiedlichen Materialvolumen bestehen, das Haftelement 7 also insbesondere aus verschiedenen Materialkomponenten bestehen. Eine Wandstärke d des Haftelements 7 seitlich der Leuchtdiode 2 in einem vom Kragen 16 unterschiedlichen Bereich beträgt hier 0,2 mm bis 1 mm.

FIG 3 zeigt in Aufsicht ein Werkzeug 17 zum Herstellen einer Leuchtvorrichtung, hier beispielhaft anhand der Leuchtvorrichtung aus FIG 1 erklärt. Das Werkzeug 17 weist eine Rinne 18 zum Einlegen des Leuchtbands 3 auf. In die Rinne 18 sind Vertiefungen 19 eingebracht, in welche das Haftelement 7 mit demjenigen (oberen) Teil eingelegt werden kann, welcher über die Vergussmasse herausragen soll. Zum Herstellen der Leuchtvorrichtung wird ein mit LEDs 2 bestücktes Flexband 3 kopfüber, d. h., mit der mit den LEDs 2 bestückten Seite in Richtung des Werkstücks 17 weisend, so in die Rinne 18 eingelegt, dass die LEDs 2 auf dem Haftelement 7 zum Liegen kommen. Im Folgenden wird der warme Heißklebstoff über Anspritzdome 20 zur Rinne 18 geleitet, wie durch den Pfeil angedeutet. Nach Abkühlen des Heißklebstoffs wird die Leuchtvorrichtung vom Werkzeug 17 getrennt.

Alternativ können die Haftelemente auch direkt auf das bestückte Flexband aufgesetzt werden, was den Vorteil hat, dass das Flexband 3 nicht umgedreht zu werden braucht.

Selbstverständlich ist die vorliegende Erfindung nicht auf die gezeigten Ausführungsbeispiele beschränkt. So können auch beidseitig mit Lichtquellen bestückte Leiterplatten zu beidseitig leuchtenden Leuchtvorrichtungen weiterverarbeitet werden.

### Bezugszeichenliste

- 1: Leuchtvorrichtung
- 2: Leuchtdiode
- 3: Flexband
- 4: Basislage
- 5: Verdrahtungslage
- 6: Oberseite der Leuchtdiode
- 7: Haftelement
- 8: Linse
- 9: Kragen
- 10: Vergussmasse
- 11: unterer Teil des Haftelements
- 12: freie Oberfläche der Vergussmasse
- 13: (oberer) Teil des Haftelements
- 14: Grenzfläche zwischen Vergussmasse und Haftelement
- 15: Leuchtvorrichtung
- 16: Kragen
- 17: Werkzeug
- 18: Rinne
- 19: Vertiefung
- 20: Anspritzdom
- d: Wandstärke

## Patentansprüche

1. Leuchtvorrichtung (1;15), aufweisend mindestens eine flexible Leiterplatte (3), die mit mindestens einer Halbleiterlichtquelle (2) bestückt ist, wobei mindestens eine bestückte Seite der Leiterplatte (3) mit einem Vergussmaterial (10) belegt ist, wobei das Vergussmaterial zumindest eine Abstrahlfläche der Halbleiterlichtquelle (2) freilässt, wobei die Halbleiterlichtquelle (2) zumindest teilweise von einem Haftelement (7) oberseitig abgedeckt ist, **dadurch gekennzeichnet, dass** das Haftelement (7) einen von der Vergussmasse (10) bedeckten seitlichen Vorsprung (9;16) aufweist, wobei das Haftelement (7) teilweise aus der Vergussmasse (10) ragt, von der Vergussmasse (10) haftend seitlich umgeben ist und eine bessere Haftung mit der Vergussmasse (10) aufweist als die Halbleiterlichtquelle (2).

2. Leuchtvorrichtung (1;15) nach Anspruch 1, bei der das Haftelement (7) eine Oberseite (6) der jeweiligen Halbleiterlichtquelle (2) vollständig überdeckt.

3. Leuchtvorrichtung (15) nach einem der vorhergehenden Ansprüche, bei der das Haftelement (7) die jeweilige Halbleiterlichtquelle (2) seitlich zumindest teilweise gegenüber der Vergussmasse (10) abdeckt, insbesondere vollständig abdeckt.

4. Leuchtvorrichtung (15) nach Anspruch 2 oder 3, bei der das Haftelement (7) einen umlaufenden, nach oben gebogenen Vorsprung (16) aufweist.

5. Leuchtvorrichtung (15) nach einem der Ansprüche 3 oder 4, bei der eine Wanddicke (d) eines die jeweilige Halbleiterlichtquelle (2) seitlich abdeckenden Bereichs des Haftelements (7) zumindest größtenteils 0,2 mm bis 1 mm beträgt.

6. Leuchtvorrichtung (1;15) nach einem der vorhergehenden Ansprüche, bei der das Haftelement (7) ein optisches Element (8), insbesondere Linse, aufweist, welches der Halbleiterlichtquelle (2) optisch nachgeschaltet ist.

7. Leuchtvorrichtung (1;15) nach Anspruch 6, bei der das optische Element (8) mittels eines Immersionsmaterials mit der Halbleiterlichtquelle (2) verbunden ist.

8. Leuchtvorrichtung (1;15) nach einem der Ansprüche 6 oder 7, bei der ein Material des optischen Elements (8) Makrolon, Silikon und / oder Glas aufweist.

9. Leuchtvorrichtung (1;15) nach einem der vorhergehenden Ansprüche, bei der die Vergussmasse (10) einen Heißklebstoff aufweist.

10. Verfahren zur Herstellung einer Leuchtvorrichtung (1;15) nach einem der vorhergehenden Ansprüche, wobei das Verfahren mindestens die folgenden Schritte aufweist:
- Zusammendrücken mindestens eines Haftelements (7) mit einer jeweiligen auf der Leiterplatte (3) befestigten Halbleiterlichtquelle (2); und
- Vergießen der bestückten Leiterplatte (3) und des mindestens einen Haftelements (7).

11. Verfahren nach Anspruch 10, welches vorher den folgenden Schritt aufweist:
- Einlegen mindestens eines Haftelements (7) in ein Werkzeug (17).

12. Verfahren nach Anspruch 10, welches zusätzlich den folgenden Schritt aufweist:
- Aufsetzen mindestens eines Haftelements (7) auf eine zugehörige Halbleiterlichtquelle (2).

## Claims

1. Lighting device (1; 15), comprising at least one flexible printed circuit board (3) populated with at least one semiconductor light source (2), wherein at least one populated side of the printed circuit board (3) is coated with a potting material (10), wherein the potting material leaves free at least one emission surface of the semiconductor light source (2), wherein the semiconductor light source (2) is at least partly covered by an adhesion element (7) on the top side, **characterized in that** the adhesion element (7) has a lateral projection (9; 16) covered by the potting compound (10), wherein the adhesion element (7) partly protrudes from the potting compound (10), is laterally surrounded adherently by the potting compound (10) and has a better adhesion to the potting compound (10) than the semiconductor light source (2).

2. Lighting device (1; 15) according to Claim 1, wherein the adhesion element (7) completely covers a top side (6) of the respective semiconductor light source (2).

3. Lighting device (15) according to either of the preceding claims, wherein the adhesion element (7) laterally at least partly covers, in particular completely covers, the respective semiconductor light source (2) with respect to the potting compound (10).

4. Lighting device (15) according to Claim 2 or 3, wherein the adhesion element (7) has a circumferential projection (16) that is bent upwards.

5. Lighting device (15) according to either of Claims 3 and 4, wherein a wall thickness (d) of a region of the adhesion element (7) which laterally covers the respective semiconductor light source (2) is at least for the most part 0.2 mm to 1 mm.

6. Lighting device (1; 15) according to any of the preceding claims, wherein the adhesion element (7) comprises an optical element (8), in particular lens, which is disposed optically downstream of the semiconductor light source (2).

7. Lighting device (1; 15) according to Claim 6, wherein the optical element (8) is connected to the semiconductor light source (2) by means of an immersion material.

8. Lighting device (1; 15) according to either of Claims 6 and 7, wherein a material of the optical element (8) comprises Makrolon, silicone and/or glass.

9. Lighting device (1; 15) according to any of the preceding claims, wherein the potting compound (10) comprises a hot melt adhesive.

10. Method for producing a lighting device (1; 15) according to any of the preceding claims, wherein the method comprises at least the following steps:
- pressing together at least one adhesion element (7) with a respective semiconductor light source (2) secured on the printed circuit board (3); and
- potting the populated printed circuit board (3) and the at least one adhesion element (7).

11. Method according to Claim 10, which beforehand comprises the following steps:
- inserting at least one adhesion element (7) into a tool (17) .

12. Method according to Claim 10, which additionally comprises the following step:
- placing at least one adhesion element (7) onto an associated semiconductor light source (2).

## Revendications

1. Dispositif d'éclairage (1 ; 15) comprenant au moins une carte à circuit imprimé souple (3) équipée d'au moins une source lumineuse à semi-conducteur (2), au moins une face ainsi équipée de ladite carte à circuit imprimé (3) étant garnie d'un matériau de scellement (10), ledit matériau de scellement laissant dégagée au moins une surface de rayonnement de la source lumineuse à semi-conducteur (2), ladite source lumineuse à semi-conducteur (2) étant recouverte sur le dessus au moins partiellement d'un élément adhésif (7), **caractérisé en ce que** ledit élément adhésif (7) possède une saillie latérale (9 ; 16) recouverte de la masse de scellement (10), ledit élément adhésif (7) débordant partiellement de la masse de scellement (10), étant entouré latéralement avec adhérence de la masse de scellement (10) et présentant une meilleure adhérence à la masse de scellement (10) que la source lumineuse à semi-conducteur (2).

2. Dispositif d'éclairage (1 ; 15) selon la revendication 1, dans lequel l'élément adhésif (7) recouvre entièrement un côté supérieur (6) de la source lumineuse à semi-conducteur respective (2).

3. Dispositif d'éclairage (1 ; 15) selon l'une des revendications précédentes, dans lequel l'élément adhésif (7) recouvre au moins partiellement, en particulier entièrement, les côtés de la source lumineuse à semi-conducteur respective (2) par rapport à la masse de scellement (10).

4. Dispositif d'éclairage (15) selon la revendication 2 ou 3, dans lequel l'élément adhésif (7) possède une saillie (16) périphérique recourbée vers le haut.

5. Dispositif d'éclairage (15) selon l'une des revendications 3 ou 4, dans lequel une épaisseur de paroi (d) d'une partie de l'élément adhésif (7) recouvrant les côtés de la source lumineuse à semi-conducteur respective (2) est au moins en grande partie comprise entre 0,2 mm et 1 mm.

6. Dispositif d'éclairage (1 ; 15) selon l'une des revendications précédentes, dans lequel l'élément adhésif (7) comporte un élément optique (8), en particulier une lentille, monté optiquement en aval de la source lumineuse à semi-conducteur (2).

7. Dispositif d'éclairage (1 ; 15) selon la revendication 6, dans lequel l'élément optique (8) est relié à la source lumineuse à semi-conducteur (2) au moyen d'un matériau à immersion.

8. Dispositif d'éclairage (1 ; 15) selon l'une des revendications 6 ou 7, dans lequel un matériau de l'élément optique (8) comporte du Macrolon, de la silicone et/ou du verre.

9. Dispositif d'éclairage (1 ; 15) selon l'une des revendications précédentes, dans lequel la masse de scellement (10) comporte un adhésif à chaud.

10. Procédé de fabrication d'un dispositif d'éclairage (1 ; 15) selon l'une des revendications précédentes, le procédé comportant au moins les étapes suivantes :
- comprimer au moins un élément adhésif (7) avec une source lumineuse à semi-conducteur respective (2), fixée sur la carte à circuit imprimé (3) ; et
- sceller la carte à circuit imprimé (3) ainsi équipée et ledit au moins un élément adhésif (7).

11. Procédé selon la revendication 10, comportant l'étape préalable suivante :
- introduire au moins un élément adhésif (7) dans un outil (17).

12. Procédé selon la revendication 10, comportant l'étape supplémentaire suivante :
- placer au moins un élément adhésif (7) sur une source lumineuse à semi-conducteur associée (2).
